(19) Europäisches Patentamt
European Patent Office
Office européen des brevets

(11) EP 1 559 738 A1

(12) EUROPEAN PATENT APPLICATION
published in accordance with Art. 158(3) EPC

(43) Date of publication:
**03.08.2005 Bulletin 2005/31**

(21) Application number: **03715653.6**

(22) Date of filing: **31.03.2003**

(51) Int Cl.⁷: **C08J 5/18**, C08G 73/10, B29C 41/12, B29C 55/12, B29C 71/02, H05K 1/03, H01L 21/60, H01L 23/50 // (C08L79/08, B29K79:00, B29L7:00)

(86) International application number:
**PCT/JP2003/004085**

(87) International publication number:
**WO 2004/031270 (15.04.2004 Gazette 2004/16)**

(84) Designated Contracting States:
**AT BE BG CH CY CZ DE DK EE ES FI FR GB GR HU IE IT LI LU MC NL PT RO SE SI SK TR**

(30) Priority: **07.10.2002 JP 2002293320**
**11.11.2002 JP 2002326454**

(71) Applicant: **TEIJIN LIMITED**
**Osaka-shi, Osaka 541-0054 (JP)**

(72) Inventors:
- **ISHIWATA, Toyoaki, Teijin Ltd, Iwakuni Research Iwakuni-shi, Yamaguchi 740-0014 (JP)**
- **NAKAMURA, Tsutomu, Teijin Ltd, Iwakuni Research Iwakuni-shi, Yamaguchi 740-0014 (JP)**
- **KOJIMA, Kazunori, Teijin Ltd, Iwakuni Research Iwakuni-shi, Yamaguchi 740-0014 (JP)**
- **SAWAKI, Toru, Teijin Ltd, Iwakuni Research Iwakuni-shi, Yamaguchi 740-0014 (JP)**

(74) Representative: **Hallybone, Huw George et al**
**Carpmaels and Ransford,**
**43-45 Bloomsbury Square**
**London WC1A 2RA (GB)**

# (54) POLYIMIDE FILM AND PROCESS FOR PRODUCING THE SAME

(57) An oriented polyimide film with a high Young's modulus, satisfactory moist heat resistance and low moisture absorptivity, and a process for its production. The polyimide film is composed mainly of a pyromellitic acid component, with a p-phenylenediamine component at between 30 mole percent and 99 mole percent and a diamine component represented by the structural unit of the following formula (II) at between 1 mole percent and 70 mole percent:

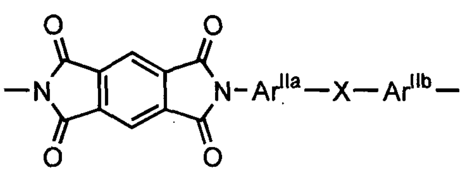

(II)

(wherein $Ar^{IIa}$ and $Ar^{IIb}$ are each independently a C6-20 aromatic group optionally having an non-reactive substituent, and X in structural unit (II) consists of at least one group selected from among -O-, $-O-Ar^{IIc}-O-$, $-SO_2-$ and $-O-Ar^{IId}-O-Ar^{IIe}-O-$),
and the polyimide film is **characterized by** having two perpendicular directions in which the in-plane Young's modulus is 3 GPa or greater, and having a moisture absorptivity of no greater than 3.3 wt% at 72% RH, 25°C.

EP 1 559 738 A1

## Description

Technical Field

The present invention relates to a polyimide film with excellent moist heat resistance, low moisture absorption and a high degree of improved mechanical properties, as well as to a process for its production.

Background Art

Wholly aromatic polyimides are widely utilized in industry for their excellent heat resistance and mechanical properties, and particularly their films are important as base materials for thin-layer electronic parts, for electronic mounting and other purposes. Increasingly thinner polyimide films are in demand due to expanding needs for smaller electronic parts in recent years, but the reduced thicknesses of films must be accompanied by high rigidity as an indispensable condition in terms of practicality and handleability.

Methods for achieving a high Young's modulus with wholly aromatic polyimide films include (1) a method of using chemical structures with high rigidity and linearity for the molecular skeleton of the polyimide, and (2) a method of using physical methods for molecular orientation of the polyimide. Materials have been studied having different combinations of pyromellitic acid or 3,3',4,4'-biphenyltetracarboxylic acid as the acid component and p-phenylenediamine or benzidine as the amine component, or their nuclear substituted forms, as the chemical structure for method (1). Among these, poly-p-phenylenepyromellitimide has the highest theoretical elastic modulus (see Journal of the Society Of Fiber Science and Technology Japan, Vol. 43, Tashiro et al. (1987)) and is inexpensive as a starting material, and it is therefore the most promising material as a high Young's modulus film material. Despite its potential, however, only very fragile poly-p-phenylenepyromellitimide films have been obtained by the ordinary conventional polyimide film production processes.

As methods of overcoming this obstacle there have been proposed, for example, a method of chemical cyclization of a polyamic acid solution obtained by reaction between p-phenylenediamine and pyromellitic anhydride (see Japanese Unexamined Patent Publication HEI No. 1-282219), and a method of adding a large amount of acetic anhydride to a polyamic acid solution obtained by reaction between a substituted p-phenylenediamine and pyromellitic anhydride to obtain a dope, casting the dope and subjected it to drying at low temperature under reduced pressure followed by heat treatment (see Japanese Unexamined Patent Publication HEI No. 6-172529). However, even the films obtained by these methods are quite brittle despite having a high Young's modulus. As methods for stretching orientation of polyimides there have been proposed, for example, a method of forming and then drying a film of a polyamic acid solution as a precursor of poly-p-phenylenepyromellitimide, uniaxially stretching the obtained polyamic acid film in a solvent and then imidating it (see Kobunshi Ronbunshu Vol.56, No.5, pp.282-290) and a method of conducting wet spinning of a precursor polyamide ester having a long chain (C10-18) ester introduced into the polymer chain, and subjecting the wet spun filament to stretching orientation followed by superheating for imidation (see Polymer Preprint Japan, Vol.141, No.9 (1992) p.3752). However, neither of these publications mention biaxial stretching with an in-plane balance, and neither method has yielded a practical poly-p-phenylenepyromellitimide film with both a high Young's modulus and toughness in an in-plane balance.

As improved methods for achieving in-plane balance there have been proposed methods wherein the polyamic acid solution is reacted with a dehydrating agent and the gel film obtained by dehydrating imidation reaction is subjected to biaxial stretching to produce a biaxially oriented polyimide film with in-plane balance (see Japanese Unexamined Patent Publication No. 2001-302821, Japanese Unexamined Patent Publication No. 2002-030519, WO-01/81456, Japanese Unexamined Patent Publication HEI No. 05-237928).

However, poly-p-phenylenepyromellitimide films, while exhibiting excellent mechanical properties, have been problematic due to their high moisture absorption whereby, for example, treatment with drastically increasing temperature in humid environments results in cracking of the members which employ the polyimide films as bases, due to gasification of moisture or generation of defects as a result of expansive deformation. Consequently, a high Young's modulus film with low moisture absorptivity has been desired. At the same time, poly-p-phenylenepyromellitimide also exhibits a reduction in physical properties in the presence of moisture. For example, the dynamic properties are notably reduced in saturated water vapor at 121°C. In addition, from the standpoint of machining process throughput and applicability to uses requiring flex resistance such as flexible printed wiring boards, poly-p-phenylenepyromellitimide films still exhibit low breaking elongation and are in need of greater toughness. It has therefore been desired to obtain a polyimide film having excellent moist heat resistance as well as more practical properties such as toughness and a high Young's modulus.

On the other hand, copolymer polyimide films obtained by copolymerization of poly-p-phenylenepyromellitimide as a constituent component and 3,4'-diaminodiphenyl ether as an aromatic diamine component have been proposed as materials with excellent mechanical properties (Japanese Unexamined Patent Publication SHO No.

62-117815). However, these are intended for fibers, whereas a sheet form having a high elastic modulus and an in-plane balance achieved by a high degree of orientation in biaxial directions is unknown. There has also been proposed a method of biaxial dry heat stretching of a polyimide film comprising pyromellitic acid at 80 mole percent or greater (100% in the examples) and 3,4'-diaminodiphenylether at 80 mole percent or greater (100% in the examples) under high temperature conditions of 250-450°C, or 350°C in the examples (see Japanese Patent No. 2626827). Although this method yields a film with a high Young's modulus, the heat resistance is still insufficient while the dimensional stability is lacking and the Young's modulus is reduced with contraction, particularly at high temperatures. Also, the temperature condition of 350°C or above is extremely high for a dry heat stretching process, and in terms of industrial productivity this increases the cost beyond a practical level. Thus, the desire remains for a high Young's modulus and high heat resistance film having low moisture absorptivity, and an excellent balance between environmental stability including moist heat resistance, as well as mechanical properties.

Disclosure of the Invention

It is an object of the present invention to provide a polyimide film with excellent moist heat resistance, low moisture absorptivity and excellent mechanical properties, and particularly a high Young's modulus.

It is another object of the invention to provide a film-forming process of a polyimide film with excellent moist heat resistance, low moisture absorptivity and high mechanical properties.

The objects and advantages of the invention will become apparent from the explanation which follows.

According to the invention, these objects and advantages are achieved, firstly, by a polyimide film comprising a structural unit of the following formula (I) at between 30 mole percent and 99 mole percent:

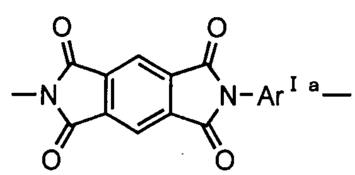

(I)

[wherein $Ar^{Ia}$ is 1,4-phenylene optionally having a non-reactive substituent], and a structural unit of the following formula (II) at between 1 mole percent and 70 mole percent:

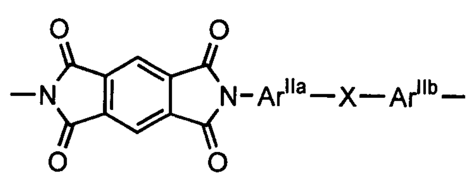

(II)

(wherein $Ar^{IIa}$ and $Ar^{IIb}$ are each independently a C6-20 aromatic group optionally having an non-reactive substituent, and X in structural unit (II) consists of at least one group selected from among groups of the following formula (II-i):

$$-O- \quad \text{(II-i)}$$

the following formula (II-ii):

$$—O\text{-}Ar^{IIc}—O— \quad \text{(II-ii)}$$

[wherein $Ar^{IIc}$ is a C6-20 aromatic group optionally having a non-reactive substituent], the following formula (II-iii):

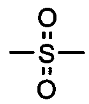

(II-iii)

and the following formula (II-iv):

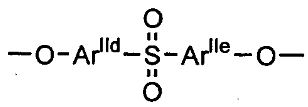

(II-iv)

[wherein $Ar^{IId}$ and $Ar^{IIe}$ are each independently a C6-20 aromatic group optionally having a non-reactive substituent], the polyimide film being characterized by having two perpendicular directions in which the in-plane Young's modulus is 3 GPa or greater, and having a moisture absorptivity of no greater than 3.3 wt% at 72% RH, 25°C.

The present invention is the result of examining techniques for high degree stretching and molecular orientation of aromatic polyimides with rigid structures, and it provides a polyimide film having an in-plane balance of mechanical properties and enhanced moist heat resistance and absorptivity, by copolymerization of structural unit (II) in a specific amount with respect to structural unit (I).

According to the invention, the aforementioned objects and advantages are achieved, secondly, by a film-forming process of a polyimide film characterized by comprising the following steps:

Step 1: A step in which (A) pyromellitic anhydride, (B) an aromatic diamine compound represented by the following formula (III):

$$H_2N\text{-}Ar^{Ia}\text{-}NH_2 \qquad \text{(III)}$$

[wherein $Ar^{Ia}$ is 1,4-phenylene optionally having a non-reactive substituent],
and (C) an aromatic diamine compound represented by the following formula (IV):

$$H_2N\text{-}Ar^{IIa}\text{—}X\text{—}Ar^{IIb}\text{-}NH_2 \qquad \text{(IV)}$$

(wherein $Ar^{IIa}$ and $Ar^{IIb}$ are each independently a C6-20 aromatic group optionally having an non-reactive substituent, and X consists of at least one group selected from among groups of the following formula (IV-i):

$$\text{-O-} \qquad \text{(IV-i)}$$

the following formula (IV-ii):

$$\text{-O-}Ar^{IIc}\text{-O-} \qquad \text{(IV-ii)}$$

[wherein $Ar^{IIc}$ is a C6-20 aromatic group optionally having a non-reactive substituent],
the following formula (IV-iii):

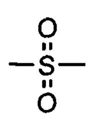

(IV-iii)

and the following formula (IV-iv):

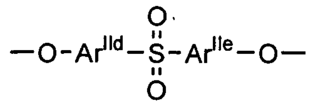

(IV-iv)

[wherein $Ar^{IId}$ and $Ar^{IIe}$ are each independently a C6-20 aromatic group optionally having a non-reactive substituent],
are reacted in a solvent in proportions simultaneously satisfying the following inequalities (1) and (2):

$$0.95 \leq a/(b+c) \leq 1.05 \quad (1)$$

$$0.01 \leq c/(b+c) \leq 0.70 \quad (2)$$

[wherein a is the number of moles of pyromellitic anhydride, b is the number of moles of the aromatic diamine compound represented by formula (III) above, and c is the number of moles of the aromatic diamine compound represented by formula (IV) above]
to obtain a polyamic acid solution;
Step 2: A step of reacting the obtained polyamic acid solution with a dehydrating agent to form a gel film wherein at least a portion of the polyamic acid is converted to polyisoimide;
Step 3: A step of biaxially stretching the obtained gel film;
Step 4: A step of heat treating the obtained biaxially stretched film.

Best Mode for Carrying Out the Invention

The polyimide film of the invention will be explained first.

The polyimide film of the invention is a polyimide film comprising
a structural unit of the following formula (I) at between 30 mole percent and 99 mole percent:

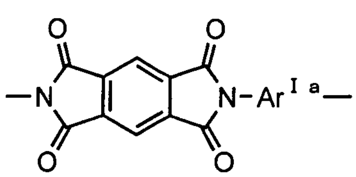

(I)

[wherein $Ar^{Ia}$ is 1,4-phenylene optionally having a non-reactive substituent], and
a structural unit of the following formula (II) at between 1 mole percent and 70 mole percent:

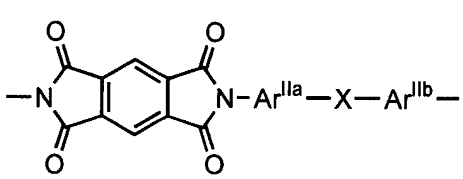

(II)

(wherein $Ar^{IIa}$ and $Ar^{IIb}$ are each independently a C6-20 aromatic group optionally having an non-reactive substituent, and X in structural unit (II) consists of at least one group selected from among groups of the following formula (II-i):

$$-O- \quad (II\text{-}i)$$

the following formula (II-ii):

$$—O\text{-}Ar^{IIc}—O— \quad \text{(II-ii)}$$

[wherein $Ar^{IIc}$ is a C6-20 aromatic group optionally having a non-reactive substituent], the following formula (II-iii) :

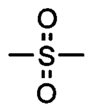

(II-iii)

and the following formula (II-iv):

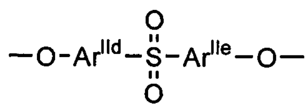

(II-iv)

[wherein $Ar^{IId}$ and $Ar^{IIe}$ are each independently a C6-20 aromatic group optionally having a non-reactive substituent], the polyimide film being characterized by having two perpendicular directions in which the in-plane Young's modulus is 3 GPa or greater, and having a moisture absorptivity of no greater than 3.3 wt% at 72% RH, 25°C.

$Ar^{Ia}$ in formula (I) above is 1,4-phenylene optionally having a non-reactive substituent, and examples of non-reactive substituents include C1-6 alkyl groups such as methyl, C1-6 alkoxy groups such as methoxy, and halogens such as chlorine and fluorine. Preferred examples of $Ar^{Ia}$ include 1,4-phenylene, 1,3-phenylene, 2-chloro-1,4-phenylene, 2-methyl-1,4-phenylene, 2,5-dichloro-1,4-phenylene, 2,5-dimethyl-1,4-phenylene, 2-chloro-5-methyl-1,4-phenylene and 2-methoxy-1,4-phenylene. As a more preferred example there may be mentioned 1,4-phenylene. Specifically, a particularly preferred example of structural unit (I) is the following formula (I-a):

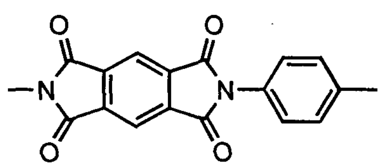

(I-a)

Two or more compounds of structural unit (I) may also be used in combination.

$Ar^{IIa}$ and $Ar^{IIb}$ are each independently a C6-20 aromatic group optionally having an non-reactive substituent. As aromatic groups there may be mentioned phenylene, naphthylene and biphenylene. The aromatic groups may also have some or all of the hydrogens substituted with non-reactive substituents. Such non-reactive substituents may include C1-6 alkyl groups such as methyl, C1-6 alkoxy groups such as methoxy, and halogens such as chlorine and fluorine. Preferred examples of $Ar^{IIa}$ and $Ar^{IIb}$ in structural unit (II) include 1,4-phenylene and/or 1,3-phenylene.

X in structural unit (II) consists of at least one group selected from among groups of formulas (II-i), (II-ii), (II-iii) and (II-iv) above.

When X is a group of formula (II-i), a particularly preferred example is a compound wherein $Ar^{IIa}$ and $Ar^{IIb}$ in structural unit (II) comprises a combination of 1,4-phenylene and 1,3-phenylene. As a specific preferred example of structural unit (II) there may be mentioned the following formula (II-i-a):

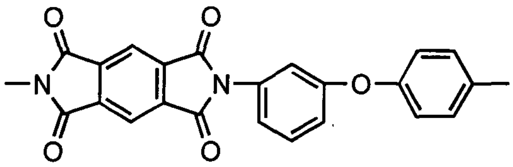

(II-i-a)

Here, the diamine component of formula (II-i-a) has a non-symmetrical structure, and it may be essentially stereoregular or non-stereoregular, although a non-stereoregular structure is preferred.

When X is a group of formula (II-ii), $Ar^{IIc}$ in formula (II-ii) is a C6-20 aromatic group optionally having a non-reactive substituent, independently of $Ar^{IIa}$ and $Ar^{IIb}$ in structural unit (II). As aromatic groups there may be mentioned phenylene, naphthylene and biphenylene. The aromatic groups may also have some or all of the hydrogens substituted with non-reactive substituents. Examples of such non-reactive substituents include C1-6 alkyl groups such as methyl, C1-6 alkoxy groups such as methoxy, and halogens such as chlorine and fluorine. Preferred examples of $Ar^{IIc}$ include 1,4-phenylene and/or 1,3-phenylene. As a particularly preferred example there may be mentioned 1,3-phenylene. In this case, 1,4-phenylene and/or 1,3-phenylene may also be mentioned as preferred examples for $Ar^{IIa}$ and $Ar^{IIb}$ in structural unit (II), with 1,3-phenylene being a particularly preferred example. Thus, as an example of a particularly preferred structural unit (II) there may be mentioned the following formula (II-ii-a):

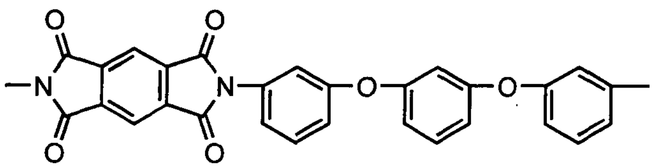

(II-ii-a)

When X is a group of formula (II-iii) above, a particularly preferred example is a compound wherein $Ar^{IIa}$ and $Ar^{IIb}$ in structural unit (II) consist of 1,3-phenylene. Specifically, as a particularly preferred example of structural unit (II) there may be mentioned the following formula (II-iii-a):

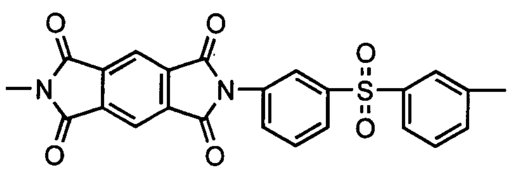

(II-iii-a)

When X is a group of formula (II-iv) above, $Ar^{IId}$ and $Ar^{IIe}$ in formula (II-iv) are each independently a C6-20 aromatic group optionally having a non-reactive substituent. As aromatic groups there may be mentioned phenylene, naphthylene and biphenylene. The aromatic groups may also have some or all of the hydrogens substituted with non-reactive substituents. Examples of such non-reactive substituents include C1-6 alkyl groups such as methyl, C1-6 alkoxy groups such as methoxy, and halogens such as chlorine and fluorine. Preferred examples of $Ar^{IId}$ and $Ar^{IIe}$ include 1,4-phenylene and/or 1,3-phenylene. As a particularly preferred example there may be mentioned 1,4-phenylene. In this case, 1,4-phenylene and/or 1,3-phenylene may also be mentioned as preferred examples for $Ar^{IIa}$ and $Ar^{IIb}$ in structural unit (II). Thus, as an example of a particularly preferred structural unit (II) there may be mentioned the following formula (II-iv-a) and/or (II-iv-b):

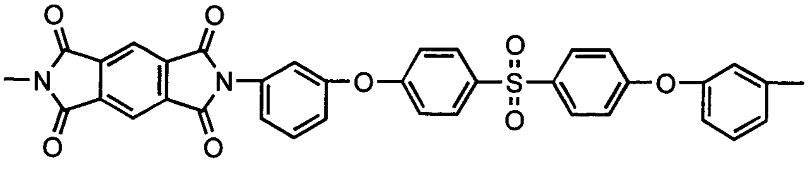

(II-iv-a)

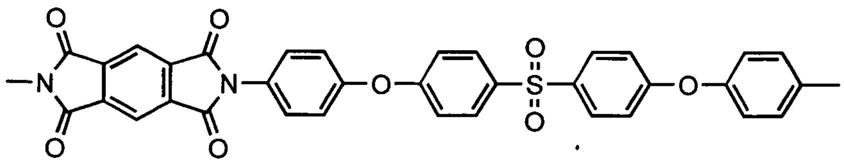

(II-iv-b)

Formula (II-iv-a) may be mentioned as a particularly preferred example among these.

Preferably, X in structural unit (II) is represented by formula (II-i), with 40-70 mole percent of structural unit (I) and 30-60 mole percent of structural unit (II). This structure will yield a polyimide film with an adequate Young's modulus and excellent moist heat resistance.

The elastic modulus of the obtained polyimide film is preferably at least 3 GPa and more preferably at least 6 GPa in two directions.

Preferably, X in structural unit (II) is at least one group selected from among (II-ii), (II-iii) and (II-iv), with 60-90 mole percent of structural unit (I) and 10-40 mole percent of structural unit (II).

Research for the present invention revealed that the imide group concentration in the polyimide is an important factor for obtaining a polyimide film having an adequate Young's modulus and excellent moist heat resistance. More specifically, the preferred composition for a polyimide film having an adequate Young's modulus and excellent moist heat resistance is a composition wherein the imide group concentration, [imide] is 5.7-6.2 eq/kg. More preferably, it is 5.8-6.1 eq/kg and even more preferably 5.85-6.05 eq/kg. The imide group concentration is the value representing the equivalents of imide groups in 1 kg of the polyimide.

This composition can yield a polyimide film with an adequate Young's modulus and excellent moist heat resistance.

The polyimide film of the invention has excellent practical properties, with a hitherto unprecedented high value for the Young's modulus and a satisfactory balance thereof. That is, it has two perpendicular directions in which the in-plane Young's modulus is 3 GPa or greater. If the Young's modulus is less than 3 GPa, the rigidity will be insufficient particularly with smaller thicknesses, and the process transportability will often be inferior. The elastic modulus of the obtained polyimide film is preferably at least 3 GPa and more preferably at least 6 GPa in two directions.

The polyimide film of the invention has a moisture absorptivity of no greater than 3.3 wt% at 72% RH, 25°C. It is preferably not 3.3 wt% or greater because high temperature heat treatment may result in decomposition of the polyimide film, or foaming due to rapid expansion of moisture. The moisture absorptivity is more preferably no greater than 3.1 wt% and even more preferably no greater than 2.9 wt%.

The polyimide film of the invention preferably has a tensile strength of at least 150 MPa in one direction. This is more preferably at least 180 MPa and even more preferably at least 200 MPa.

The polyimide film of the invention also preferably has a tensile breaking elongation of at least 3% in one direction. This is more preferably at least 5% and even more preferably at least 10%.

The imide group fraction in the polyimide of the polyimide film of the invention is preferably at least 95%. The imide group fraction is preferably not less than 95% because the hydrolysis resistance of the polyimide film will be reduced.

The imide group fraction is the proportion (mole percent) of imide group nitrogen atoms with respect to the total of the amic acid nitrogen atoms and imide group nitrogen atoms in the polyimide film.

As a result of studying techniques for high degree stretching and molecular orientation of aromatic polyimides with rigid structures, the present inventors discovered that a gel prepared by employing a specific process for chemical treatment of a precursor amic acid, having structural unit (II) copolymerized in a specific amount with structural unit (I), has a high stretching property at low temperatures near room temperature, and that therefore stretching of the gel in an expanded state followed by heat treatment can yield a polyimide film with an excellent Young's modulus, a balance of in-plane mechanical properties and improved moisture absorptivity.

The imide group fraction in the polyimide of the polyimide film of the invention is preferably at least 95%. The imide group fraction is preferably not less than 95% because the hydrolysis resistance of the polyimide film will be reduced. The imide group fraction is defined in the examples.

The polyimide film of the invention has excellent practical properties, including a hitherto unprecedented high value for the Young's modulus and a satisfactory balance of the Young's modulus in the film plane. That is, it has two perpendicular directions in which the Young's modulus is greater than 3 GPa in the plane of the film. Preferably, the plane of the film has two perpendicular directions in which the Young's modulus is greater than 6 GPa.

The polyimide film of the invention preferably has a tensile strength of at least 150 MPa in one direction. The tensile strength is more preferably at least 300 MPa and even more preferably at least 400 MPa in one direction.

The production process for the polyimide film of the invention will now be explained.

The production process of the invention comprises the following steps (1) to (4).

Step 1: A step in which (A) pyromellitic anhydride, (B) an aromatic diamine compound represented by the following formula (III):

$$H_2N\text{-}Ar^{Ia}\text{-}NH_2 \quad \text{(III)}$$

[wherein $Ar^{Ia}$ is 1,4-phenylene optionally having a non-reactive substituent], and (C) an aromatic diamine compound represented by the following formula (IV):

$$H_2N\text{-}Ar^{IIa}—X—Ar^{IIb}\text{-}NH_2 \quad \text{(IV)}$$

(wherein $Ar^{IIa}$ and $Ar^{IIb}$ are each independently a C6-20 aromatic group optionally having an non-reactive substituent, and X consists of at least one group selected from among groups of the following formula (IV-i):

$$—O— \quad \text{(IV-i)}$$

the following formula (IV-ii):

$$—O\text{-}Ar^{IIc}—O— \quad \text{(IV-ii)}$$

[wherein $Ar^{IIc}$ is a C6-20 aromatic group optionally having a non-reactive substituent], the following formula (IV-iii):

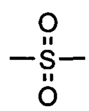

(IV-iii)

and the following formula (IV-iv):

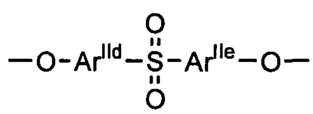

(IV-iv)

[wherein $Ar^{IId}$ and $Ar^{IIe}$ are each independently a C6-20 aromatic group optionally having a non-reactive substituent], are reacted in a solvent in proportions simultaneously satisfying the following inequalities (1) and (2):

$$0.95 \leq a/(b+c) \leq 1.05 \quad (1)$$

$$0.01 \leq c/(b+c) \leq 0.70 \quad (2)$$

[wherein a is the number of moles of pyromellitic anhydride, b is the number of moles of the aromatic diamine compound represented by formula (III) above, and c is the number of moles of the aromatic diamine compound represented by formula (IV) above]
to obtain a polyamic acid solution;

Step 2: A step of reacting the obtained polyamic acid solution with a dehydrating agent to form a gel film wherein at least a portion of the polyamic acid is converted to polyisoimide;
Step 3: A step of biaxially stretching the obtained gel film;
Step 4: A step of heat treating the obtained biaxially stretched film.

In Step 1, solution polymerization of the polyamic acid is carried out to prepare a polyamic acid solution. Any publicly known method of the prior art may be employed for the polymerization process for the polyamic acid.
$Ar^{Ia}$ in formula (III) above is 1,4-phenylene optionally having a non-reactive substituent. Specifically, it is the same as in structural unit (I) described above. Thus, examples of particularly preferred aromatic diamine compounds represented by formula (III) above include compounds represented by the following formula (III-a):

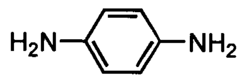

(III-a)

Two or more of the aromatic diamine compounds represented by formula (III) above may be used in combination.
$Ar^{IIa}$ and $Ar^{IIb}$ in formula (IV) above are each independently a C6-20 aromatic group optionally having an non-reactive substituent or ether bond. Specifically, they are the same as in structural unit (II) described above. In addition, X in formula (IV) above consists of at least one group selected from among groups of formulas (IV-i), (IV-ii), (IV-iii) and (IV-iv). These are substantially the same as formulas (II-i), (II-ii), (II-iii) and (II-iv) in structural unit (II). Therefore, particularly preferred examples of aromatic diamine compounds represented by formula (IV) above include compounds represented by formulas (IV-i-a), (IV-ii-a), (IV-iii-a), (IV-iv-a) and (IV-iv-b):

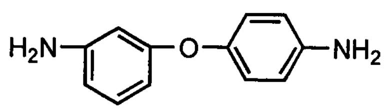

(IV-i-a)

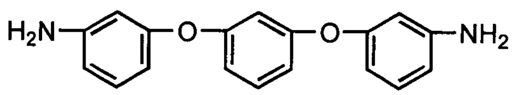

(IV-ii-a)

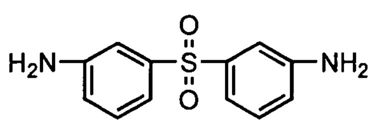

(IV-iii-a)

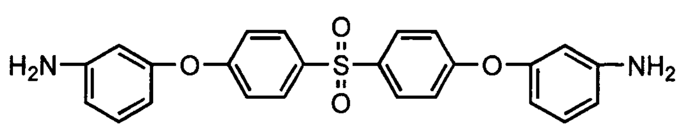

(IV-iv-a)

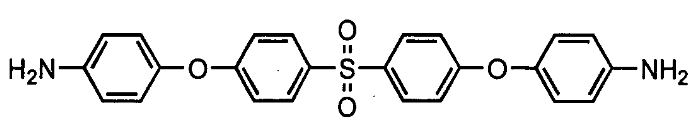

(IV-iv-b)

The aromatic diamine compounds represented by formulas (IV-i-a), (IV-ii-a), (IV-iv-a) and (IV-iv-b) above will hereinafter be referred to as 3,4'-DAPE, APB, BAPS-M and BAPS. Two or more of the aromatic diamine compounds represented by formula (IV) above may be used in combination. An example of a particularly preferred structural unit is 3,4'-DAPE

of formula (IV-i-a).

In formulas (1) and (2) above, a is the number of moles of pyromellitic anhydride, b is the number of moles of the aromatic diamine compound represented by formula (III) above, and c is the number of moles of the aromatic diamine compound represented by formula (IV) above. If the value of a/(b+c) is less than 0.95 or larger than 1.05, the polymerization degree of the obtained polyamic acid will be low, rendering film formation more difficult. The value is preferably at least 0.97 and less than 1.03.

The value of c/(b+c) is between 0.01 and 0.7. When the aromatic diamine compound represented by formula (IV) above is of formula (IV-i-a), the value of c/(b+c) is preferably between 0.3 and 0.6.

When the aromatic diamine compound is (IV-ii-a), (IV-iii-a), (IV-iv-a) or (IV-iv-b), the value of c/(b+c) is preferably between 0.1 and 0.4.

As explained above for the polyimide composition, research for the present invention has revealed that the imide group concentration in the polyimide is an important factor for obtaining a polyimide film having an adequate Young's modulus and excellent moist heat resistance. More specifically, the preferred charging ratio for the aromatic tetracarboxylic acid dianhydride and aromatic diamine compound is a charging ratio in a proportion such that the imide group concentration in the polyimide of the obtained polyimide film, [imide] is 5.7-6.2 eq/kg. More preferably, it is a charging ratio such that [imide] is 5.8-6.1 eq/kg and even more preferably 5.85-6.05 eq/kg. The imide group concentration is the value representing the equivalents of imide groups in 1 kg of the polyimide.

There are no particular restrictions on the method of charging the starting materials (A), (B) and (C), and the order of addition and method of addition may be any existing methods. Preferably, the diamine components (B) and (C) are first dissolved in the solvent, and then component (A) is added at the desired reaction temperature and polymerization is conducted. The addition of component (A) may involve addition of the prescribed amount in one stage, or divided over several times. Divided addition over several times is particularly preferred in cases where reaction temperature control is difficult by the reaction heat.

The reaction temperature during polymerization of the polyamic acid is preferably between -20°C and 80°C. The reaction temperature is preferably not below -20°C because the reaction rate will be insufficient. If it is higher than 80°C, partial imidation may result and side-reactions may occur, often making it impossible to stably obtain the polyamic acid. The reaction temperature is more preferably between -10°C and 70°C, and even more preferably between 0°C and 50°C.

As reaction solvents there may be mentioned solvents comprising at least one compound selected from the group consisting of N-methyl-2-pyrrolidone (hereinafter abbreviated as NMP), N,N-dimethylformamide, N,N-dimethylacetamide and 1,3-dimethylimidazolidinone. NMP and/or N,N-dimethylacetamide are preferred, with NMP being more preferred.

The concentration of the polyamic acid solution is preferably between 0.1 wt% and 30 wt%. If it is less than 0.1 wt%, it will be difficult to sufficiently promote polymerization and the resulting solution may not have sufficient viscosity to form a film. If the concentration is greater than 30 wt%, the viscosity may be too high, which can also result in a solution with an inferior film-forming property. The concentration is preferably between 1 wt% and 25 wt%, and even more preferably between 1.5 wt% and 20 wt%. During and/or after polymerization of the polyamic acid, the solvent may be diluted to adjust the concentration of the finally obtained polyamic acid solution.

Step 1 according to the invention is preferably carried out under low humidity conditions. For example, it is preferably carried out in a low humidity inert gas atmosphere, such as nitrogen or argon, or a dry air atmosphere. Also, the starting materials and solvent used in Step 1 are preferably used in as dry a form as possible.

The ends of the polyamic acid in the polyamic acid solution are preferably capped. When an end capping agent is used for capping, the preferred examples of end capping agents which may be mentioned include phthalic anhydride and its substituted forms, hexahydrophthalic anhydride and its substituted forms and succinic anhydride and it substituted forms (as acid anhydride components), and aniline and its substituted forms (as amine components). As particularly preferred examples among these there may be mentioned phthalic anhydride and its substituted forms and/or aniline and its substituted forms. There are no particular restrictions on the stage for addition of the end capping agent, and it may be carried out during charging of the polyamic acid polymerization starting materials, during the polymerization, or after completion of the polymerization. The amount of addition may be sufficient to essentially terminate polymerization and stabilize the viscosity of the polyamic acid solution, and the optimum addition amount may be determined based on simple experimentation.

In Step 2, the obtained polyamic acid solution is reacted with a dehydrating agent to form a gel film wherein at least a portion of the polyamic acid is converted to polyisoimide. More specifically, acetic anhydride as dehydrating agent and an organic amine are added to the polyamic acid solution prepared in Step 1 to obtain a polyamic acid composition which is then cast onto a support and subjected to warming/heat treatment for dehydration reaction to form a gel film wherein at least a portion of the polyamic acid is converted to polyimide or polyisoimide (Method 1). Alternatively, the polyamic acid solution prepared in Step 1 is cast onto a support to obtain a film, and the obtained film is dipped together with the support into an isoimidating solution comprising the same solvent as in Step 1 and

acetic anhydride as dehydrating agents and an organic amine, to form a gel film wherein at least a portion of the polyamic acid is converted to polyisoimide (Method 2). Two specific methods will now be explained.

As Method 1 for obtaining a gel film by reaction with a dehydrating agent, specifically, an organic amine is first added to and mixed with the polyamic acid solution prepared in Step 1. As examples of organic amine compounds, where the organic amine used acts as a reaction catalyst for the acetic anhydride and polyamic acid, there may be used tertiary aliphatic amines such as trimethylamine, triethylamine, tributylamine, diisopropylethylamine and triethylenediamine; aromatic amines such as N,N-dimethylaniline and 1,8-bis(N,N-dimethylamino)naphthalene, and heterocyclic compounds such as pyridine and its derivatives, picoline and its derivatives, lutidine, quinoline, isoquinoline, 1,8-diazabicyclo[5.4.0]undecene and N,N-dimethylaminopyridine. Pyridine and picoline are preferred among these from the standpoint of economy. Also, triethylenediamine and N,N-dimethylaminopyridine allow a very high imide group fraction to be achieved in combination with acetic anhydride, and are preferred in order to yield a gel film with high resistance to moisture. The amount of the organic amine compound added is in the range of 0.1-20 moles to 1 mole of polyamic acid repeating units. At less than 0.1 mole, a sufficient effect cannot be obtained from the addition. At greater than 20 moles, the viscosity of the obtained composition will be undesirably reduced. The range is more preferably 0.5-10 moles. The mixing temperature for the polyamic acid solution and organic amine is preferably in the range of -30°C to 30°C. The mixing temperature is preferably not higher than 30°C because the polyamic acid will lack viscosity stability. At a temperature of below -30°C, the viscosity of the polyamide solution will be excessively high to the point of resulting in difficult mixing. The temperature range is more preferably - 25°C to 10°C. If necessary, acetic acid may be further added to inhibit volatilization of the organic amine compound. When acetic acid is added, there are no restrictions on the method and order of adding the organic amine compound and acetic acid, but the preferred method is addition of a preformed salt of the organic amine compound and acetic acid. The amount of acetic acid is not particularly restricted put is preferably no greater than 4 moles and more preferably no greater than 2 moles of acetic acid for 1 mole of the organic amine compound. Acetic anhydride is then mixed with the resulting solution. The amount of acetic anhydride used is preferably 0.1-20 moles to 1 mole of polyamic repeating units. At less than 0.1 mole, the reaction may be insufficient and the obtained gel film may be brittle. At greater than 20 moles, the viscosity and solubility may be reduced, leading to loss of transparency of the gel film. The range is preferably 0.5-10 moles. The acetic anhydride is preferably mixed in a temperature range of -30°C to 30°C. The mixing temperature is preferably not higher than 30°C because the polyamic acid will lack stable viscosity. If the temperature is below -30°C, the viscosity of the polyamide solution will be excessively high to the point of resulting in difficult mixing. The temperature range is more preferably -25°C to 10°C. Any publicly known method of the prior art may be employed for kneading of the organic amine compound and acetic anhydride. For example, for continuous kneading, the method may employ a kneader, extruder, static mixer, Banbury mixer or the like. For batch kneading, kneading may be carried out in a vessel equipped with a stirrer. The organic amine compound and acetic anhydride added to and kneaded in the polyamic acid solution in the manner described above may be added directly or after dilution in N,N-dimethylacetamide.

As Method 2 for Step 2, the polyamic acid solution prepared in Step 1 is cast onto a support to obtain a film, and the obtained film is dipped together with the support into an isoimidating solution comprising the same solvent as in Step 1 and acetic anhydride as dehydrating agents and an organic amine, to form a gel film wherein at least a portion of the polyamic acid is converted to polyisoimide.

A commonly known film-forming process such as a wet or dry-wet molding process may be used for casting of the polyamic acid solution on the support. Examples of film-forming processes include die extrusion processes, casting using an applicator, or coater processes. A metal belt or casting drum may be used as the support for casting of the polyamic acid. Also, the casting may be on an organic polymer film such as polyester or polypropylene, with direct introduction into a condensation agent solution. These steps are preferably carried out in a low humidity atmosphere.

Examples of organic amine compounds which may be used to act as reaction catalysts for the acetic anhydride and polyamic acid include tertiary aliphatic amines such as trimethylamine, triethylamine, tributylamine, diisopropylethylamine and triethylenediamine; aromatic amines such as N,N-dimethylaniline and 1,8-bis(N,N-dimethylamino) naphthalene, and heterocyclic compounds such as pyridine and its derivatives, picoline and its derivatives, lutidine, quinoline, isoquinoline, 1,8-diazabicyclo[5.4.0]undecene and N,N-dimethylaminopyridine. Pyridine and picoline are preferred among these from the standpoint of economy. Also, triethylenediamine and N,N-dimethylaminopyridine allow a very high imide group fraction to be achieved in combination with acetic anhydride, and are preferred in order to yield a gel film with high resistance to moisture. The amount of the organic amine compound with respect to the acetic anhydride is not particularly restricted but is preferably at least 0.5 mole percent and more preferably at least 10 mole percent.

No specific concentration is necessary for the acetic anhydride in the solution mixture, but in order to adequately promote the reaction it is preferably between 0.5 wt% and 99 wt%. It is more preferably between 30 wt% and 99 wt%. The reaction temperature is not particularly restricted and may be above the solidification point and below the boiling point in the solution mixture.

One of the major features of the second production process is that in Step 2, the acetic anhydride and polyamic acid are reacted in a solvent which can dissolve the polyamic acid, in the presence of an organic amine compound catalyst, to yield a uniform and highly expanded undrawn gel film with excellent stretching properties.

In Step 2, a gel film is formed having at least a portion of the polyamic acid converted to polyisoimide. The isoimide group fraction of the gel film is preferably 90% or greater in order to obtain a high draw ratio.

Examples of organic amines which may be used in Method 2 to act as reaction catalysts for the acetic anhydride and polyamic acid include tertiary aliphatic amines such as trimethylamine, triethylamine, tributylamine, diisopropylethylamine and triethylenediamine; aromatic amines such as N,N-dimethylaniline and 1,8-bis(N,N-dimethylamino) naphthalene, and heterocyclic compounds such as pyridine and its derivatives, picoline and its derivatives, lutidine, quinoline, isoquinoline, 1,8-diazabicyclo[5.4.0]undecene and N,N-dimethylaminopyridine. Pyridine and picoline are preferred among these from the standpoint of economy. Also, triethylenediamine and N,N-dimethylaminopyridine allow a very high imide group fraction to be achieved in combination with acetic anhydride, and are preferred in order to yield a gel film with high resistance to moisture. The amount of the organic amine with respect to the acetic anhydride is not particularly restricted but is preferably at least 0.5 mole percent, more preferably at least 10 mole percent, and even more preferably 50 mole percent. No specific concentration is necessary for the acetic anhydride in the solution mixture, but in order to adequately promote the reaction it is preferably between 0.5 wt% and 99 wt%, and more preferably between 30 wt% and 99 wt%. The reaction temperature is not particularly restricted and may be above the solidification point and below the boiling point in the solution mixture.

Examples of processes for production of the polyamic acid solution include a technique by die extrusion, casting using an applicator, or a method using a coater. A metal belt or casting drum may be used as the support for casting of the polyamic acid. Also, the casting may be on an organic polymer film such as polyester or polypropylene, with direct introduction into a condensation agent solution.

Step 2 is preferably carried out in a low humidity atmosphere. In Step 2, the polyamic acid is reacted with the dehydrating agent to yield a uniform and highly expanded undrawn gel film with excellent stretching properties.

In Step 2, a gel film is formed having at least a portion of the polyamic acid converted to polyisoimide. The isoimide group fraction of the gel film is preferably 2% or greater in order to obtain a high draw ratio. The isoimide group fraction is more preferably 3% or greater and even more preferably 10% or greater. This may be considered one of the major features of Step 2 in order to yield a uniform and highly expanded undrawn gel film with excellent stretching stability. The method of calculating the isoimide group fraction and imide group fraction of the gel film will be explained in detail below, but these may be easily calculated from the infrared absorption spectrum.

A commonly known film-forming processes, such as a wet or dry molding process, may be employed for formation of the film by casting onto a support. Examples of film-forming processes include a technique by die extrusion, casting using an applicator, or a method using a coater. A metal belt or casting drum may be used as the support for casting of the polyamic acid. Also, the support used may be an organic polymer film such as polyester or polypropylene.

As organic amines there may be mentioned tertiary aliphatic amines such as trimethylamine, triethylamine, tributylamine, diisopropylethylamine and triethylenediamine; aromatic amines such as N,N-dimethylaniline and 1,8-bis (N,N-dimethylamino)naphthalene, and pyridine derivatives such as pyridine and 4-(N,N-dimethyl)aminopyridine, and picoline and its derivatives. Preferably used among these are pyridine, triethylenediamine, picoline and 4-(N,N-dimethyl)aminopyridine, with pyridine and triethylenediamine being particularly preferred.

The amount of the imidating/isoimidating agent used and the concentration of the solution are not particularly restricted. In the two methods, the amount may be that which is sufficient for chemical reaction of the amide acid to an imide/isoimide, although the optimum amount will differ depending on the conditions such as the reaction time, temperature, polyamic acid concentration and casting thickness.

The proportion of imide/isoimide in the obtained gel film is not particularly restricted. The proportion will differ significantly according to the type of imidating agent.

As mentioned above, the gel film obtained in Step 2 is a uniform and highly expanded gel film with excellent stretching properties. Obtaining a gel film with such excellent stretching properties is a special feature of the invention, and is essential for obtaining a highly oriented polyimide film in the subsequent steps.

The gel film of Step 2 also preferably has an isoimide group fraction and imide group fraction total of no greater than 60% of the polymer component. If the total is 60% or greater, the orienting effect by stretching in the subsequent Step 3 will be insufficient, degradation may occur in the subsequent Step 4, or the mechanical properties may be reduced. The total is more preferably 80% or greater. The method of calculating the total of the isoimide group fraction and imide group fraction of the gel film will be explained in detail below, but it may be easily calculated from the infrared absorption spectrum.

Step 2 according to the invention is preferably carried out in a low humidity atmosphere. It is preferably carried out in an inert gas atmosphere, such as nitrogen or argon, or a dry air atmosphere, and more preferably in a dry air atmosphere from the standpoint of industrial production cost.

The gel film may also have the imidation catalyst and organic solvents other than washing solvent removed

by washing. There are no particular restrictions on the washing method, temperature or time, and for example, washing may be accomplished by dipping the gel film in an organic solvent such as any of those mentioned as solvents for Step 1, an aromatic hydrocarbon such as toluene or another alkylbenzene, an aliphatic alcohol such as isopropyl alcohol, or a higher alcohol, benzyl alcohol, an ester-based organic solvent, a ketone-based organic solvent or the like. Particularly in the case of a gel film obtained using dicyclohexyl carbodiimide, the gel film will contain numerous isoimide groups and therefore in order to obtain an efficient stretching orientation effect in the subsequent steps it is preferred to perform adequate washing with toluene or the like. On the other hand, in the case of a gel film obtained using a fatty acid anhydride and an organic amine, the gel film will contain relatively more imide groups and therefore the washing is preferably performed using the same organic solvent as the polyamic acid polymerization solvent. The gel film may be washed while it is on the support, but the washing is not limited to Step 2 and may also be divided into separate periods including, for example, the period after separation from the support in Step 3 or even after stretching.

In Step 3, the gel film obtained in Step 2 is separated from the support and then subjected to biaxial stretching. The stretching may be carried out to a factor of 1.03-10.0 in both the lengthwise and widthwise directions. The factor is preferably 1.05-8.00 and more preferably 1.10-6.00. The stretching temperature is not particularly restricted, but is preferably between -10°C and 100°C. The temperature is more preferably between -5°C and 90°C and even more preferably between 0°C and 80°C. The stretching may be accomplished by sequential stretching or simultaneous biaxial stretching. It may be carried out in any atmosphere, including a solvent, air or an inert atmosphere. As a particularly preferred example there may be mentioned stretching in air.

The gel film provided for biaxial stretching in Step 3 preferably has a swelling degree of 200-10,000%. If it is lower than 200%, a sufficient stretching property may not be achieved. On the other hand, if it is higher than 10,000% the film may not be adequately self-supporting, thereby presenting a practical difficulty for the stretching step. The swelling degree is more preferably 250-9000% and even more preferably 300-8000%.

Finally, in Step 4, the biaxially stretched film obtained in Step 3 is heat treated to form a biaxially oriented polyimide film. The heat treatment method may be hot air heating, vacuum heating, infrared heating or microwave heating, or heating by contact with a hot plate, hot roll or the like. Stepwise raising of the temperature is preferred in order to promote removal and drying of the solvent, imidation and/or conversion of isoimides to imides.

The heat treatment may be carried out at a constant length or under tension. The heat treatment temperature is not particularly restricted in terms of the initial temperature, but the maximum temperature for the heat treatment is preferably 250-650°C. It may be carried out while gradually raising and/or lowering the temperature in stages. In any case, the heat treatment can inhibit relaxation of the orientation while obtaining a polyimide film with an imidation rate of over 95%. Heat treatment at below 250°C is not preferred as it will not easily produce an imidation rate of over 95%, or may require a longer time to achieve an imidation rate of over 95%. Heat treatment at above 650°C is also not preferred because it may cause heat degradation of the polyimide. The temperature is preferably 300-600°C and more preferably 350-550°C.

The biaxially oriented polyimide film obtained in the manner described above has its molecular chains strongly oriented in the plane of the film and is therefore a polyimide film having a high Young's modulus with an excellent in-plane balance and exhibiting enhanced strength, since its Young's modulus measured in two orthogonal directions in the plane will be, preferably, greater than 3 GPa and more preferably greater than 6 GPa, and a special microstructure is formed by stretching orientation. This high Young's modulus polyimide film is highly rigid and can therefore be suitably used for electronic purposes, and for example, as a support for electrical wiring boards laminated with thin copper films, even if the film has a small thickness of 10 μm or smaller. It may also be used as a support for metal wiring circuit boards, flexible circuit boards, TAB (tape automated bonding) tape and LOC (lead-on-chip) tape. It may also be used as a base film for magnetic recording tape.

## Examples

The process of the invention will now be explained in greater detail through the following examples. These examples, however, are not intended to restrict the scope of the invention in any way.

The reducing viscosity of the polyamic acid was measured with a 1 wt% lithium chloride/NMP solution as the dissolving solution, a polymer concentration of 0.05 wt% and a temperature of 0°C.

The swelling degree (wt/wt%) was calculated by the following formula (3):

$$\text{Swelling degree (wt/wt\%)} = (Ww/Wd-1) \times 100 \qquad (3)$$

based on the weight in a wet swelled state (Ww) and the weight in a dry state (Wd).

The tensile strength, breaking elongation and Young's modulus were measured using an Orientech UCT-1T, with a 50 mm x 10 mm sample at a pull speed of 5 mm/min.

The isoimide group fraction and imide group fraction were calculated from the following formulas (4) and (5) based on measurement by the transmission method using a Fourier transform infrared spectrophotometer (Nicolet Magna 750).

$$\text{Isoimide group fraction (\%)} = (A_{920}/A_{1024})/11.3 \times 100 \qquad (4)$$

$A_{920}$: Absorption intensity of isoimide bond-derived peak (920 $cm^{-1}$) for sample.
$A_{1024}$: Absorption intensity of benzene ring-derived peak (1024 $cm^{-1}$) for sample.

$$\text{Imide group fraction (\%)} = (A_{720}/A_{1024})/5.1 \times 100 \qquad (5)$$

$A_{720}$: Absorption intensity of imide bond-derived peak (720 $cm^{-1}$) for sample. $A_{1024}$: Absorption intensity of benzene ring-derived peak (1024 $cm^{-1}$) for sample.

Pressure cooker treatment (PCT): The film was subjected to moist heat treatment at 121°C, 100% RH, 24 hrs in a HAST chamber (EHS-221M) manufactured by Tabai Espec.

The moisture absorptivity was determined by allowing the sample to stand in an atmosphere of 25°C, 72% RH for 72 hours, measuring the weight (W1), and then drying the sample for 30 minutes in a hot air drier at 270°C and measuring the weight (W2) and performing calculation by the following formula (6):

Moisture absorptivity (wt/wt%) = (W1/W2-1) x 100 (6).

The imide group concentration, [imide] of the polyimide is the value representing the equivalents of imide groups in 1 kg of the polyimide, and it is calculated by the following formula (7):

$$\text{[imide] (eq/kg)} = 2000/\text{(mean molecular weight of repeating unit)} \qquad (7).$$

Comparative Example 1

After placing 1920 g of dehydrated N-methyl-2-pyrrolidone (NMP) in a reactor equipped with a thermometer, stirrer and starting material charging inlet under a nitrogen atmosphere, 26.52 g of p-phenylenediamine was added and the mixture was thoroughly dissolved. It was then cooled in an ice bath to adjust the diamine solution temperature to 3°C. Next, 53.46 g of pyromellitic anhydride was added to the cooled diamine solution and reaction was conducted for 1 hour. The temperature of the reaction solution was 5-20°C. The reaction solution was reacted for 3 hours at room temperature (23°C), and then 0.091 g of phthalic anhydride was added and reacted therewith for 1 hour for amine end capping, to obtain a polyamic acid NMP solution as a viscous solution. The reducing viscosity of the obtained polyamic acid was 13.8.

The polyamic acid solution was cast onto a glass panel using a doctor blade with a thickness of 1.0 mm, and then dipped for 30 minutes in a 30°C dehydrating condensation bath comprising 250 ml of acetic anhydride, 74 g of triethylenediamine and 2000 ml of NMP for imidation/isoimidation, after which the resulting gel film was separated from the glass panel support. The imide group fraction of the gel film was 83%, and the isoimide group fraction was 3%.

The obtained gel film was dipped in NMP at room temperature for 20 minutes for washing, and then both ends of the gel film were anchored with a chuck and simultaneous biaxial stretching was carried out at a speed of 10 mm/sec, to a factor of 1.05 in each of the orthogonal biaxial directions at room temperature. The swelling degree of the gel film at the start of stretching was 1510%.

The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film.

The thickness of the polyimide film, Young's modulus, tensile strength and breaking elongation measured in the two orthogonal directions in the plane, and the imide group fraction are shown in Table 1. The film was subjected to PCT treatment, but was too brittle to allow evaluation of the mechanical properties.

The value of [imide] for the polyimide film was 6.89 eq/kg.

Example 1

After placing 2010 g of dehydrated NMP in a reactor equipped with a thermometer, stirrer and starting material charging inlet under a nitrogen atmosphere, 40.95 g of p-phenylenediamine and 91.77 g of 3,4'-DAPE (aromatic diamine compound represented by formula (IV-i-a) above) were added and the mixture was thoroughly dissolved. It was then cooled in an ice bath to adjust the diamine solution temperature to 3°C. Next, 181.8 g of pyromellitic anhydride was added to the cooled diamine solution and reaction was conducted for 1 hour. the temperature of the reaction solution was 5-20°C. The reaction solution was reacted for 8 hours at room temperature (23°C). Next, 0.247 g of phthalic anhydride was added and reacted therewith for 1 hour for amine end capping, to obtain a polyamic acid NMP solution as a viscous solution. The polyamic acid NMP concentration was 13 wt% and the reducing viscosity was 6.39.

The 13 wt% polyamic acid NMP solution was cast onto a glass panel using a doctor blade with a thickness of 1.0 mm, and then dipped for 30 minutes in a 30°C dehydrating condensation bath comprising 1050 ml of acetic anhydride, 450 ml of pyridine and 1500 ml of NMP for imidation/isoimidation, after which the resulting gel film was separated from the glass panel support. The imide group fraction of the gel film was 82%, and the isoimide group fraction was 18%.

The obtained gel film was dipped in NMP at room temperature for 20 minutes for washing, and then both ends of the gel film were anchored with a chuck and simultaneous biaxial stretching was carried out at a speed of 10 mm/sec, to a factor of 3.10 in each of the orthogonal biaxial directions at room temperature. The swelling degree of the gel film at the start of stretching was 394%.

The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film.

The thickness, Young's modulus, tensile strength and breaking elongation measured in the two orthogonal directions in the plane and the imide group fraction of the polyimide film are shown in Table 1. The film was subjected to PCT treatment, and no notable degradation was observed. The Young's modulus, tensile strength and breaking elongation after PCT treatment are shown in Table 1.

The value of [imide] for the polyimide film was 5.87 eq/kg.

Example 2

After placing 1800 g of dehydrated NMP in a reactor equipped with a thermometer, stirrer and starting material charging inlet under a nitrogen atmosphere, 58.03 g of p-phenylenediamine and 11.93 g of 3,4'-DAPE (aromatic diamine compound represented by formula (IV-i-a) above) were added and the mixture was thoroughly dissolved. It was then cooled in an ice bath to adjust the diamine solution temperature to 3°C. Next, 130.0 g of pyromellitic anhydride was added to the cooled diamine solution and reaction was conducted for 1 hour. the temperature of the reaction solution was 5-20°C. The reaction solution was reacted for 8 hours at room temperature (23°C). Next, 0.221 g of phthalic anhydride was added and reacted therewith for 1 hour for amine end capping, to obtain a polyamic acid NMP solution as a viscous solution. This was diluted with dehydrated NMP to a polyamic acid concentration of 4 wt%, and supplied for film formation. The reducing viscosity of the polyamic acid was 7.94.

The 4 wt% polyamic acid NMP solution was cast onto a glass panel using a doctor blade with a thickness of 1.5 mm, and then dipped for 30 minutes in a 30°C dehydrating condensation bath comprising 1050 ml of acetic anhydride, 450 ml of pyridine and 1500 ml of NMP for imidation/isoimidation, after which the resulting gel film was separated from the glass panel support. The imide group fraction of the gel film was 49%, and the isoimide group fraction was 41%.

The obtained gel film was dipped in NMP at room temperature for 20 minutes for washing, and then both ends of the gel film were anchored with a chuck and simultaneous biaxial stretching was carried out at a speed of 10 mm/sec, to a factor of 1.80 in each of the orthogonal biaxial directions at room temperature. The swelling degree of the gel film at the start of stretching was 1820%.

The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film. The thickness of the polyimide film, the Young's modulus, tensile strength and elongation measured in the two orthogonal directions in the plane, and the moisture absorptivity and imide group fraction are shown in Table 1.

The value of [imide] for the polyimide film was 6.68 eq/kg.

Example 3

The 4 wt% polyamic acid NMP solution obtained in Example 2 was supplied for film formation. The polyamic acid NMP solution was cast in the same manner as Example 2 and subjected to gelling reaction to obtain a gel film.

The imide group fraction of the gel film was 45%, and the isoimide group fraction was 43%.

The gel film was then stretched in the same manner as Example 2, except that the stretching factor was 1.90 in the orthogonal biaxial directions. The film was also dried and heated in the same manner as Example 2, except that the heat treatment final temperature was 450°C. The thickness of the polyimide film, the Young's modulus, tensile strength and elongation measured in the two orthogonal directions in the plane, and the moisture absorptivity and imide group fraction are shown in Table 1.

The value of [imide] for the polyimide film was 6.68 eq/kg.

Example 4

Polymerization of polyamic acid was conducted in the same manner as Example 2, except that the amounts were 50.20 g of p-phenylenediamine, 23.22 g of 3,4'-DAPE, 126.5 g of pyromellitic anhydride and 0.215 g of phthalic anhydride. The solution was diluted with dehydrated NMP to a polyamic acid concentration of 5 wt%, and supplied for film formation. The reducing viscosity of the polyamic acid was 10.8.

The 5 wt% polyamic acid NMP solution was used for film formation in the same manner as Example 2 to obtain a gel film. The imide group fraction of the gel film was 39%, and the isoimide group fraction was 38%. A polyimide film was obtained in the same manner as Example 2, except that the stretching factor was 2.10 in the orthogonal biaxial directions. The swelling degree of the gel film at the start of stretching was 1910%. The thickness of the polyimide film, the Young's modulus, tensile strength and elongation measured in the two orthogonal directions in the plane, and the moisture absorptivity and imide group fraction are shown in Table 1.

The value of [imide] for the polyimide film was 6.48 eq/kg.

Example 5

Polymerization of polyamic acid was conducted in the same manner as Example 2, except that the amounts were 42.79 g of p-phenylenediamine, 33.93 g of 3,4'-DAPE, 123.2 g of pyromellitic anhydride and 0.209 g of phthalic anhydride. The solution was diluted with dehydrated NMP to a polyamic acid concentration of 6 wt%, and supplied for film formation. The reducing viscosity of the polyamic acid was 7.91.

The 6 wt% polyamic acid NMP solution was used for film formation in the same manner as Example 2 to obtain a gel film. The imide group fraction of the gel film was 46%, and the isoimide group fraction was 31%. A polyimide film was obtained in the same manner as Example 2, except that the stretching factor was 2.40 in the orthogonal biaxial directions. The swelling degree of the gel film at the start of stretching was 1990%. The thickness of the polyimide film, the Young's modulus, tensile strength and elongation measured in the two orthogonal directions in the plane, and the moisture absorptivity and imide group fraction are shown in Table 1.

The value of [imide] for the polyimide film was 6.29 eq/kg.

Table 1

| | I (mol%) | II (mol%) | Thickness (µm) | PCT | Measuring direction | Young's modulus (GPa) | Strength (MPa) | Elongation (%) | Moisture absorptivity (%) | Imide group fraction (%) |
|---|---|---|---|---|---|---|---|---|---|---|
| Comp. Ex. 1 | 100 | 0 | 21 | untreated | MD<br>TD | 15<br>14 | 370<br>360 | 4<br>3 | 4.8 | 99 |
| | | | | treated | MD<br>TD | not measured | not measured | not measured | | - |
| Example 1 | 45 | 55 | 12 | untreated | MD<br>TD | 9<br>9 | 320<br>330 | 30<br>31 | - | - |
| | | | | treated | MD<br>TD | 10<br>9 | 280<br>270 | 20<br>24 | - | - |
| Example 2 | 90 | 10 | 15 | untreated | MD<br>TD | 10<br>11 | 429<br>433 | 9<br>6 | 3.2 | 99 |
| Example 3 | 90 | 10 | 12 | untreated | MD<br>TD | 12<br>13 | 260<br>330 | 9<br>15 | 3.1 | 99 |
| Example 4 | 90 | 20 | 11 | untreated | MD<br>TD | 12<br>11 | 280<br>300 | 8<br>24 | 2.7 | 99 |
| Example 5 | 70 | 30 | 9 | untreated | MD<br>TD | 10<br>10 | 330<br>270 | 34<br>27 | 1.9 | 99 |

Example 6

After placing 1800 g of dehydrated NMP in a reactor equipped with a thermometer, stirrer and starting material charging inlet under a nitrogen atmosphere, 56.47 g of p-phenylenediamine and 16.96 g of APB (aromatic diamine compound represented by formula (IV-ii-a) above) were added and the mixture was thoroughly dissolved. It was then cooled in an ice bath to adjust the diamine solution temperature to 3°C. Next, 126.5 g of pyromellitic anhydride was added to the cooled diamine solution and reaction was conducted for 1 hour. the temperature of the reaction solution was 5-20°C. The reaction solution was reacted for 8 hours at room temperature (23°C). Next, 0.215 g of phthalic anhydride was added and reacted therewith for 1 hour for amine end capping, to obtain a polyamic acid NMP solution as a viscous solution. This was diluted with dehydrated NMP to a polyamic acid concentration of 4 wt%, and supplied for film formation. The reducing viscosity of the polyamic acid was 13.5.

The 4 wt% polyamic acid NMP solution was cast onto a glass panel using a doctor blade with a thickness of 1.5 mm, and then dipped for 30 minutes in a 30°C dehydrating condensation bath comprising 1050 ml of acetic anhydride, 450 ml of pyridine and 1500 ml of NMP for imidation/isoimidation, after which the resulting gel film was separated from the glass panel support. The imide group fraction of the gel film was 44%, and the isoimide group fraction was 38%.

The obtained gel film was dipped in NMP at room temperature for 20 minutes for washing, and then both ends of the gel film were anchored with a chuck and simultaneous biaxial stretching was carried out at a speed of 10 mm/sec, to a factor of 1.84 in each of the orthogonal biaxial directions at room temperature. The swelling degree of the gel film at the start of stretching was 1900%.

The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film. The thickness of the polyimide film, the Young's modulus, tensile strength and elongation measured in the two orthogonal directions in the plane, and the moisture absorptivity and imide group fraction are shown in Table 2.

The value of [imide] for the polyimide film was 6.48 eq/kg.

Example 7

A polyimide film was obtained in the same manner as Example 6, except that the stretching factor was 1.80 in each of the orthogonal biaxial directions. The thickness of the polyimide film, the Young's modulus, tensile strength and breaking elongation measured in the two orthogonal directions in the plane, and the moisture absorptivity and imide group fraction are shown in Table 2.

The value of [imide] for the polyimide film was 6.48 eq/kg.

Example 8

A polyimide film was obtained in the same manner as Example 6, except that the stretching factor was 1.65 in each of the orthogonal biaxial directions. The thickness of the polyimide film, the Young's modulus, tensile strength and breaking elongation measured in the two orthogonal directions in the plane, and the moisture absorptivity and imide group fraction are shown in Table 2.

The value of [imide] for the polyimide film was 6.48 eq/kg.

Example 9

A polyimide film was obtained in the same manner as Example 6, except that the final heat treatment temperature in the film-forming step was 350°C. The thickness of the polyimide film, the Young's modulus, tensile strength and breaking elongation measured in the two orthogonal directions in the plane, and the moisture absorptivity and imide group fraction are shown in Table 2.

The value of [imide] for the polyimide film was 6.48 eq/kg.

Example 10

Polymerization of polyamic acid was conducted in the same manner as Example 6, except that the amounts were 47.65 g of p-phenylenediamine, 32.20 g of APB (aromatic diamine compound represented by formula (IV-ii-a) above), 120.1 g of pyromellitic anhydride and 0.20 g of phthalic anhydride. The solution was diluted with dehydrated NMP to a polyamic acid concentration of 5 wt%, and supplied for film formation. The reducing viscosity of the polyamic acid was 10.8.

The 5 wt% polyamic acid NMP solution was used for film formation in the same manner as Example 6 to

obtain a gel film. The imide group fraction of the gel film was 44%, and the isoimide group fraction was 38%. Stretching was carried out in the same manner as Example 6, except that the stretching factor was 1.86 in the orthogonal biaxial directions. The swelling degree of the gel film at the start of stretching was 2180%. The gel film was heat treated in the same manner as Example 6 to obtain a polyimide film. The thickness of the polyimide film, the Young's modulus, tensile strength and breaking elongation measured in the two orthogonal directions in the plane, and the moisture absorptivity and imide group fraction are shown in Table 2.

The value of [imide] for the polyimide film was 6.11 eq/kg.

Example 11

Polymerization of polyamic acid was conducted in the same manner as Example 6, except that the amounts were 39.68 g of p-phenylenediamine, 45.97 g of APB (aromatic diamine compound represented by formula (IV-ii-a) above), 114.3 g of pyromellitic anhydride and 0.19 g of phthalic anhydride. The solution was diluted with dehydrated NMP to a polyamic acid concentration of 6 wt%, and supplied for film formation. The reducing viscosity of the polyamic acid was 11.9.

The 6 wt% polyamic acid NMP solution was used for film formation in the same manner as Example 6 to obtain a gel film. The imide group fraction of the gel film was 44%, and the isoimide group fraction was 39%. Stretching was carried out in the same manner as Example 6, except that the stretching factor was 2.00 in the orthogonal biaxial directions. The swelling degree of the gel film at the start of stretching was 2320%. The gel film was heat treated in the same manner as Example 6 to obtain a polyimide film. The thickness of the polyimide film, the Young's modulus, tensile strength and breaking elongation measured in the two orthogonal directions in the plane, and the moisture absorptivity and imide group fraction are shown in Table 2.

The film was subjected to PCT treatment, and no notable degradation was observed. The Young's modulus, tensile strength and breaking elongation after PCT treatment are shown in Table 2.

The value of [imide] for the polyimide film was 5.79 eq/kg.

Example 12

The 5 wt% polyamic acid NMP solution obtained in Example 10 was used for film formation in the same manner as Example 2, except that the composition of the dehydrating condensation bath was 250 ml of acetic anhydride, 74 g of triethylenediamine and 2000 ml of NMP, to obtain a gel film. The imide group fraction of the gel film was 96%, and the isoimide group fraction was 1%. Stretching was carried out in the same manner as Example 6, except that the stretching factor was 1.46 in the orthogonal biaxial directions. The swelling degree of the gel film at the start of stretching was 1620%. The gel film was heat treated in the same manner as Example 6 to obtain a polyimide film. The thickness of the polyimide film, the Young's modulus, tensile strength and breaking elongation measured in the two orthogonal directions in the plane, and the moisture absorptivity and imide group fraction are shown in Table 2.

The value of [imide] for the polyimide film was 6.11 eq/kg.

Table 2

| | I (mol%) | II (mol%) | Thickness (µm) | PCT | Measuring direction | Young's modulus (GPa) | Strength (MPa) | Elongation (%) | Moisture absorptivity (%) | Imide group fraction (%) |
|---|---|---|---|---|---|---|---|---|---|---|
| Example 6 | 90 | 10 | 14 | untreated | MD<br>TD | 15<br>15 | 429<br>433 | 10<br>10 | 2.9 | 98 |
| Example 7 | 90 | 10 | 15 | untreated | MD<br>TD | 16<br>13 | 444<br>464 | 14<br>15 | 2.8 | 99 |
| Example 8 | 90 | 10 | 19 | untreated | MD<br>TD | 14<br>15 | 391<br>428 | 10<br>12 | 3.0 | 99 |
| Example 9 | 90 | 10 | 16 | untreated | MD<br>TD | 13<br>14 | 341<br>352 | 17<br>12 | 2.8 | 99 |
| Example 10 | 80 | 20 | 23 | untreated | MD<br>TD | 13<br>14 | 385<br>405 | 12<br>16 | 2.5 | 99 |
| Example 11 | 70 | 30 | 18 | untreated | MD<br>TD | 13<br>13 | 397<br>382 | 21<br>16 | 1.8 | 99 |
| | | | | treated treated | MD<br>TD | 14<br>14 | 338<br>351 | 17<br>14 | - | - |
| Example 12 | 80 | 20 | 27 | untreated | MD<br>TD | 13<br>13 | 395<br>403 | 22<br>19 | 2.4 | 98 |

Example 13

After placing 1800 g of dehydrated NMP in a reactor equipped with a thermometer, stirrer and starting material charging inlet under a nitrogen atmosphere, 54.27 g of p-phenylenediamine and 24.10 of BAPS-M (aromatic diamine compound represented by formula (IV-iv-a) above) were added and the mixture was thoroughly dissolved. It was then cooled in an ice bath to adjust the diamine solution temperature to 3°C. Next, 121.4 g of pyromellitic anhydride was added to the cooled diamine solution and reaction was conducted for 1 hour. the temperature of the reaction solution was 5-20°C. The reaction solution was reacted for 4 hours at room temperature (23°C). Next, 0.206 g of phthalic anhydride was added and reacted therewith for 1 hour for amine end capping, to obtain a polyamic acid NMP solution as a viscous solution. This was diluted with dehydrated NMP to a polyamic acid concentration of 5 wt%, and supplied for film formation. The reducing viscosity of the polyamic acid was 6.1.
The 5 wt% polyamic acid NMP solution was cast onto a glass panel using a doctor blade with a thickness of 1.5 mm, and then dipped for 30 minutes in a 30°C dehydrating condensation bath comprising 1050 ml of acetic anhydride, 450 ml of pyridine and 1500 ml of NMP for imidation/isoimidation, after which the resulting gel film was separated from the glass panel support. The imide group fraction of the gel film was 41%, and the isoimide group fraction was 39%.
The obtained gel film was dipped in NMP at room temperature for 20 minutes for washing, and then both ends of the gel film were anchored with a chuck and simultaneous biaxial stretching was carried out at a speed of 10 mm/sec, to a stretching factor of 1.8 in each of the orthogonal biaxial directions at room temperature. The swelling degree of the gel film at the start of stretching was 1860%.
The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film. The thickness of the polyimide film, the Young's modulus, tensile strength and elongation measured in the two orthogonal directions in the plane, and the moisture absorptivity and imide group fraction are shown in Table 1.
The value of [imide] for the polyimide film was 6.20 eq/kg.

Example 14

A polyimide film was obtained in the same manner as Example 13, except that the stretching factor was 1.58 in each of the orthogonal biaxial directions. The thickness of the polyimide film, the Young's modulus, tensile strength and elongation measured in the two orthogonal directions in the plane, and the moisture absorptivity and imide group fraction are shown in Table 3.
The value of [imide] for the polyimide film was 6.20 eq/kg.

Example 15

A polyimide film was obtained in the same manner as Example 13, except that the factor was 1.58 in each of the orthogonal biaxial directions and the heat treatment final temperature was 350°C. The thickness of the polyimide film, the Young's modulus, tensile strength and elongation measured in the two orthogonal directions in the plane, and the moisture absorptivity and imide group fraction are shown in Table 3.
The value of [imide] for the polyimide film was 6.20 eq/kg.

Example 16

A 5 wt% polyamic acid NMP solution obtained in the same manner as Example 13 was cast onto a glass panel using a doctor blade with a thickness of 1.0 mm, and then dipped for 30 minutes in a 30°C dehydrating condensation bath comprising 250 ml of acetic anhydride, 74 g of triethylenediamine and 2000 ml of NMP for imidation/isoimidation, after which the resulting gel film was separated from the glass panel support. The imide group fraction of the gel film was 96%, and the isoimide group fraction was 2%.
The obtained gel film was dipped in NMP at room temperature for 20 minutes for washing, and then both ends of the gel film were anchored with a chuck and simultaneous biaxial stretching was carried out at a speed of 10 mm/sec, to a stretching factor of 1.4 in each of the orthogonal biaxial directions at room temperature. The swelling degree of the gel film at the start of stretching was 1860%.
The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film. The thickness of the polyimide film, the Young's modulus, tensile strength and elongation measured in the two orthogonal directions in the plane, and the moisture absorptivity and imide group fraction are shown in Table 1.

The value of [imide] for the polyimide film was 6.20 eq/kg.

Example 17

Polymerization was conducted in the same manner as Example 13, except that the amounts were 35.75 g of p-phenylenediamine, 61.23 g of BAPS-M (aromatic diamine compound represented by formula (IV-iv-a) above), 103.0 g of pyromellitic anhydride and 0.176 g of phthalic anhydride, and the polymerization time was 6 hours. The solution was diluted with dehydrated NMP to a polyamic acid concentration of 6 wt%, and supplied for film formation. The reducing viscosity of the polyamic acid was 7.2.
The 6 wt% polyamic acid NMP solution was used for film formation in the same manner as Example 13 to obtain a gel film. The imide group fraction of the gel film was 43%, and the isoimide group fraction was 35%. Stretching was carried out in the same manner as Example 14, except that the stretching factor was 2.1 in the orthogonal biaxial directions. The swelling degree of the gel film at the start of stretching was 2120%. The gel film was heat treated in the same manner as Example 13 to obtain a polyimide film. The thickness of the polyimide film, the Young's modulus, tensile strength and elongation measured in the two orthogonal directions in the plane, and the moisture absorptivity and imide group fraction are shown in Table 3.
The value of [imide] for the polyimide film was 5.16 eq/kg.

Example 18

Polymerization was conducted in the same manner as Example 13, except that the monomer starting material amounts were 54.27 g of p-phenylenediamine, 24.10 g of BAPS (aromatic diamine compound represented by formula (IV-iv-b) above) and 121.4 g of pyromellitic anhydride, to obtain a 5 wt% polyamic acid NMP solution. The reducing viscosity of the polyamic acid was 7.6.
The 6 wt% polyamic acid NMP solution was used for film formation, stretching and heat treatment in the same manner as Example 13. The imide group fraction of the obtained gel film was 44%, the isoimide group fraction was 32%, and the swelling degree of the gel film at the start of stretching was 1790%. The thickness of the polyimide film, the Young's modulus, tensile strength and elongation measured in the two orthogonal directions in the plane, and the moisture absorptivity and imide group fraction are shown in Table 3.
The value of [imide] for the polyimide film was 6.20 eq/kg.

Example 19

Polymerization was conducted in the same manner as Example 13, except that the monomer starting material amounts were 57.20 g of p-phenylenediamine, 14.59 g of bis(3-aminophenyl)sulfone and 128.1 g of pyromellitic anhydride, to obtain a 5 wt% polyamic acid NMP solution. The reducing viscosity of the polyamic acid was 8.3.
The 6 wt% polyamic acid NMP solution was used for film formation, stretching and heat treatment in the same manner as Example 13. The imide group fraction of the obtained gel film was 38%, the isoimide group fraction was 39%, and the swelling degree of the gel film at the start of stretching was 1840%. The thickness of the polyimide film, the Young's modulus, tensile strength and elongation measured in the two orthogonal directions in the plane, and the moisture absorptivity and imide group fraction are shown in Table 3.
The value of [imide] for the polyimide film was 6.57 eq/kg.

Table 3

| | I (mol%) | II (mol%) | Thickness (μm) | PCT | Measuring direction | Young's modulus (GPa) | Strength (MPa) | Elongation (%) | Moisture absorptivity (%) | Imide group fraction (%) |
|---|---|---|---|---|---|---|---|---|---|---|
| Example 13 | 90 | 10 | 17 | untreated | MD<br>TD | 16<br>15 | 428<br>407 | 12<br>11 | 3.1 | 99 |
| Example 14 | 90 | 10 | 26 | untreated | MD<br>TD | 13<br>13 | 392<br>372 | 8<br>7 | 3.2 | 99 |
| Example 15 | 90 | 10 | 25 | untreated | MD<br>TD | 12<br>11 | 314<br>284 | 5<br>7 | 3.2 | 99 |
| Example 16 | 90 | 10 | 29 | untreated | MD<br>TD | 13<br>11 | 368<br>381 | 10<br>10 | 3.3 | 99 |
| Example 17 | 70 | 30 | 10 | untreated | MD<br>TD | 11<br>10 | 373<br>354 | 21<br>18 | 1.8 | 99 |
| Example 18 | 90 | 10 | 16 | untreated | MD<br>TD | 16<br>16 | 380<br>392 | 9<br>10 | 3.0 | 99 |
| Example 19 | 90 | 10 | 17 | untreated | MD<br>TD | 15<br>14 | 378<br>381 | 11<br>10 | 3.1 | 99 |

Example 20

After placing 20 L of dehydrated NMP with a moisture content of 10 ppm in a reactor equipped with a thermometer, stirrer and starting material charging inlet under a nitrogen atmosphere, 225.29 g of p-phenylenediamine and 417.41 g of 3,4'-DAPE (aromatic diamine compound represented by formula (IV-i-a) above) were added and the mixture was thoroughly dissolved. It was then cooled in an ice bath to adjust the diamine solution temperature to -5°C. Next, 909.08 g of pyromellitic anhydride was added to the cooled diamine solution and reaction was conducted for 1 hour. the temperature of the reaction solution was 0-5°C. The reaction solution was reacted for 4 hours at 10-15°C. Next, 1.23 g of phthalic anhydride was added and reacted therewith for 2 hours for amine end capping, to obtain a polyamic acid NMP solution as a viscous solution. The concentration of the polyamic acid NMP solution was 7 wt%, and the reducing viscosity of the polyamic acid was 9.1.

The obtained 7 wt% polyamic acid NMP solution was cooled to -10°C under a nitrogen atmosphere, and then pyridine was added at a proportion of 4 moles of pyridine to 1 mole of polyamic acid repeating units, mixing was performed with a static mixer, acetic anhydride was added at a proportion of 6 moles of acetic anhydride to 1 mole of polyamic acid repeating units, and mixing was continued with the static mixer. The obtained polyamic acid NMP solution composition was a viscous solution even without dehydration reaction. The polyamic acid NMP solution composition was cast onto a PET film to a thickness of 0.5 mm by die extrusion. It was then heated to 40°C together with the PET film support. The heating produced a dehydration reaction, and after 1 hour of heating, the whole support was dipped into NMP at room temperature for washing. Separation from the support yielded a uniform, highly stretchable gel film. The imide group fraction of the gel film was 74%, and the isoimide group fraction was 21%.

Both ends of the gel film were anchored with a chuck and simultaneous biaxial stretching was carried out at a speed of 10 mm/sec, to a stretching factor of 2.4/2.8 in the MD direction/TD direction, respectively, at room temperature. The swelling degree of the gel film at the start of stretching was 1181%.

The stretched film was fixed onto a frame and the temperature was raised in stages from 160°C to 300°C with a hot air drier using dry air, for drying and heat treatment. Next, a hot air circulating oven was used for stepwise temperature increase from 300°C to 450°C to obtain a polyimide film. The thickness of the polyimide film, the Young's modulus, tensile strength and breaking elongation measured in the two orthogonal directions in the plane, and the moisture absorptivity and imide group fraction are shown in Table 4.

The value of [imide] for the polyimide film was 5.95 eq/kg.

Example 21

The polyamic acid NMP solution composition obtained in Example 20 was used to obtain a gel film in the same manner as Example 20, except that the thickness was 1.0 mm. The imide group fraction of the gel film was 71%, and the isoimide group fraction was 28%.

Both ends of the gel film were anchored with a chuck and simultaneous biaxial stretching was carried out at a speed of 10 mm/sec, to a stretching factor of 2.1/2.7 in the MD direction/TD direction, respectively, at room temperature. The swelling degree of the gel film at the start of stretching was 1283%.

The stretched gel film was subjected to drying and heat treatment in the same manner as Example 20 to obtain a polyimide film. The thickness of the polyimide film, the Young's modulus, tensile strength and breaking elongation measured in the two orthogonal directions in the plane, and the moisture absorptivity and imide group fraction are shown in Table 4.

The film was subjected to PCT treatment, and no notable degradation was observed. The Young's modulus, tensile strength and breaking elongation after PCT treatment are shown in Table 4.

The value of [imide] for the polyimide film was 5.95 eq/kg.

Table 4

| | I (mol%) | II (mol%) | Thickness (μm) | PCT | Measuring direction | Young's modulus (GPa) | Strength (MPa) | Elongation (%) | Moisture absorptivity (%) | Imide group fraction (%) |
|---|---|---|---|---|---|---|---|---|---|---|
| Example 20 | 50 | 50 | 5 | untreated | MD | 9 | 313 | 34 | 1.8 | 98 |
| | | | | | TD | 9 | 318 | 31 | | |
| Example 21 | 50 | 50 | 12 | untreated | MD | 9 | 368 | 48 | 1.7 | 99 |
| | | | | | TD | 9 | 337 | 51 | | |
| | | | | treated | MD | 10 | 325 | 35 | - | - |
| | | | | | TD | 9 | 312 | 36 | | |

## Claims

1. A polyimide film comprising a structural unit of the following formula (I) at between 30 mole percent and 99 mole percent:

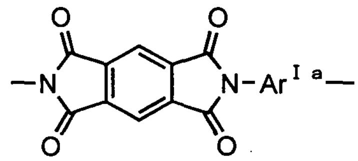

(I)

[wherein $Ar^{Ia}$ is 1,4-phenylene optionally having a non-reactive substituent], and a structural unit of the following formula (II) at between 1 mole percent and 70 mole percent:

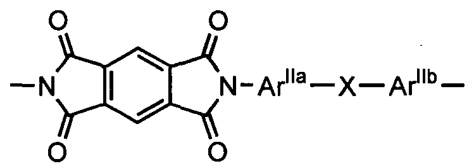

(II)

(wherein $Ar^{IIa}$ and $Ar^{IIb}$ are each independently a C6-20 aromatic group optionally having an non-reactive substituent, and X in structural unit (II) consists of at least one group selected from among groups of the following formula (II-i):

$$-O- \quad \text{(II-i)}$$

the following formula (II-ii):

$$-O-Ar^{IIc}-O- \quad \text{(II-ii)}$$

[wherein $Ar^{IIc}$ is a C6-20 aromatic group optionally having a non-reactive substituent], the following formula (II-iii):

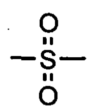

(II-iii)

and the following formula (II-iv):

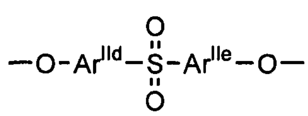

(II-iv)

[wherein $Ar^{IId}$ and $Ar^{IIe}$ are each independently a C6-20 aromatic group optionally having a non-reactive substituent],

the polyimide film being **characterized by** having two perpendicular directions in which the in-plane Young's modulus is 3 GPa or greater, and having a moisture absorptivity of no greater than 3.3 wt% at 72% RH, 25°C.

2. A polyimide film according to claim 1, **characterized in that** X in structural unit (II) is represented by formula (II-i), with 40-70 mole percent of structural unit (I) and 30-60 mole percent of structural unit (II).

3. A polyimide film according to claim 1, **characterized in that** X in structural unit (II) consists of at least one group selected from among groups of formulas (II-ii), (II-iii) and (II-iv), with 70-95 mole percent of structural unit (I) and 10-40 mole percent of structural unit (II).

4. A polyimide film according to claim 1, **characterized in that** the imide group concentration, [imide] of the polyimide used is 5.7-6.2 eq/kg.

5. A polyimide film according to claim 2, **characterized in that** structural unit (II) is a structure represented by the following formula (II-a):

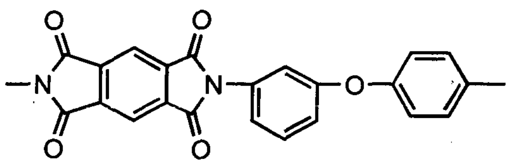

(II-a)

6. A polyimide film according to claim 1, **characterized in that** the tensile strength in one direction is 150 MPa or greater.

7. A polyimide film according to claim 1, wherein the imide group fraction of the polyimide is 95% or greater.

8. A film-forming process of a polyimide film **characterized by** comprising the following steps:

Step 1: A step in which (A) pyromellitic anhydride, (B) an aromatic diamine compound represented by the following formula (III):

$$H_2N\text{-}Ar^{Ia}\text{-}NH_2 \qquad (III)$$

[wherein $Ar^{Ia}$ is 1,4-phenylene optionally having a non-reactive substituent],
and (C) an aromatic diamine compound represented by the following formula (IV):

$$H_2N\text{-}Ar^{IIa}—X—Ar^{IIb}\text{-}NH_2 \qquad (IV)$$

(wherein $Ar^{IIa}$ and $Ar^{IIb}$ are each independently a C6-20 aromatic group optionally having an non-reactive substituent, and X consists of at least one group selected from among groups of the following formula (IV-i):

$$—O— \qquad (IV\text{-}i)$$

the following formula (IV-ii):

$$—O\text{-}Ar^{IIc}—O— \qquad (IV\text{-}ii)$$

[wherein $Ar^{IIc}$ is a C6-20 aromatic group optionally having a non-reactive substituent],
the following formula (IV-iii):

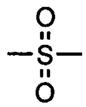

(IV-iii)

and the following formula (IV-iv):

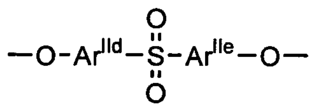

(IV-iv)

[wherein $Ar^{IId}$ and $Ar^{IIe}$ are each independently a C6-20 aromatic group optionally having a non-reactive substituent],
are reacted in a solvent in proportions simultaneously satisfying the following inequalities (1) and (2):

$$0.95 \leq a/(b+c) \leq 1.05 \quad (1)$$

$$0.01 \leq c/(b+c) \leq 0.70 \quad (2)$$

[wherein a is the number of moles of pyromellitic anhydride, b is the number of moles of the aromatic diamine compound represented by formula (III) above, and c is the number of moles of the aromatic diamine compound represented by formula (IV) above]
to obtain a polyamic acid solution;
Step 2: A step of reacting the obtained polyamic acid solution with a dehydrating agent to form a gel film wherein at least a portion of the polyamic acid is converted to polyisoimide;
Step 3: A step of biaxially stretching the obtained gel film;
Step 4: A step of heat treating the obtained biaxially stretched film.

**9.** A film-forming process of a polyimide film according to claim 8, **characterized in that** in Step 2, acetic anhydride as dehydrating agent and an organic amine are added to the polyamic acid solution prepared in Step 1 to obtain a polyamic acid composition which is then cast onto a support and subjected to warming/heat treatment for dehydration reaction to form a gel film wherein at least a portion of the polyamic acid is converted to polyimide or polyisoimide.

**10.** A film-forming process of a polyimide film according to claim 8, **characterized in that** in Step 2, the polyamic acid solution prepared in Step 1 is cast onto a support to obtain a film, and the obtained film is dipped together with the support into an isoimidating solution comprising the same solvent as in Step 1 and acetic anhydride as dehydrating agents and an organic amine, to form a gel film wherein at least a portion of the polyamic acid is converted to polyisoimide.

**11.** A film-forming process of a polyimide film according to claim 8, wherein the isoimide group fraction of the gel film obtained in Step 2 is 90% or greater.

**12.** A film-forming process of a polyimide film according to claim 8, wherein the gel film supplied for biaxial stretching in Step 3 has a swelling degree of 200-10,000%.

**13.** A film-forming process of a polyimide film according to claim 8, wherein the heat treatment of Step 4 is carried out at a constant length or under tension, at a temperature of 250-650°C.

**14.** A metal wiring circuit board comprising a polyimide film according to claim 1.

**15.** An LOC tape comprising a polyimide film according to claim 1.

## INTERNATIONAL SEARCH REPORT

International application No.
PCT/JP03/04085

**A. CLASSIFICATION OF SUBJECT MATTER**

Int.Cl7 C08J5/18, C08G73/10, B29C41/12, B29C55/12, B29C71/02, H05K1/03, H01L21/60, H01L23/50//C08L79:08, B29K79:00, B29L7:00

According to International Patent Classification (IPC) or to both national classification and IPC

**B. FIELDS SEARCHED**

Minimum documentation searched (classification system followed by classification symbols)

Int.Cl7 C08J5/18, C08G73/10, B29C41/12, B29C55/12, B29/C71/02, H05K1/03, H01L21/60, H01L23/50

Documentation searched other than minimum documentation to the extent that such documents are included in the fields searched

| | | | |
|---|---|---|---|
| Jitsuyo Shinan Koho | 1926-1996 | Jitsuyo Shinan Toroku Koho | 1996-2003 |
| Kokai Jitsuyo Shinan Koho | 1971-2003 | Toroku Jitsuyo Shinan Koho | 1994-2003 |

Electronic data base consulted during the international search (name of data base and, where practicable, search terms used)

CAS ONLINE

**C. DOCUMENTS CONSIDERED TO BE RELEVANT**

| Category* | Citation of document, with indication, where appropriate, of the relevant passages | Relevant to claim No. |
|---|---|---|
| X<br>A | WO 02/16475 A2 (E.I. DU PONT DE NEMOURS AND CO.), 28 February, 2002 (28.02.02), Claims; page 7, lines 5 to 11; page 11, lines 3 to 12; page 11, lines 22 to 31; page 12, lines 1 to 8; page 12, line 23 to page 13, lines 5, 35 to 38<br>& JP 2002-138152 A<br>Page 5, Par. No. [0037]; page 6, Par. Nos. [0054], [0056], [0058] to [0060]; pages 6 to 7, Par. Nos. [0063] to [0064]; page 7, Par. No. [0069]<br>& AU 200185217 A | 1,2,4-15<br>3 |
| X<br>A | JP 2001-81213 A (Du Pont-Toray Co., Ltd.), 27 March, 2001 (27.03.01), Claims; page 4, Par. No. [0020]; Figs. 4 to 5; example 1; page 6; table 1<br>(Family: none) | 1,2,4,6-14<br>3,5,15 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>15 May, 2003 (15.05.03) | Date of mailing of the international search report<br>27 May, 2003 (27.05.03) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP03/04085

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2000-80165 A (Du Pont-Toray Co., Ltd.),<br>21 March, 2000 (21.03.00),<br>Claims; page 9, Par. No. [0091]; table 2;<br>comparative example 8<br>(Family: none) | 1,3,4,6-15<br>2,5 |
| E,X<br>E,A | JP 2003-109989 A (Du Pont-Toray Co., Ltd.),<br>11 April, 2003 (11.04.03),<br>Claims; pages 3 to 4, Par. Nos. [0025] to [0026];<br>page 4, Par. Nos. [0044] to [0045]; page 6;<br>table 3; comparative example 2<br>(Family: none) | 1,2,4-14<br>3,15 |
| A | WO 01/81456 A1 (TEIJIN LTD.),<br>01 November, 2001 (01.11.01),<br>Claims; page 8, line 25 to page 10, line 12;<br>page 15, lines 11 to 21<br>& EP 1275681 A1<br>Page 5, Par. Nos. [0022] to [0028]; page 8,<br>Par. No. [0056]<br>& AU 200148811 A & KR 2002093043 A | 1-15 |
| A | EP 276405 A2 (Kanegafuchi Chemical Industry Co., Ltd.),<br>03 August, 1988 (03.08.88),<br>Claims<br>& JP 1-131241 A & DE 3789296 G<br>& US 4886874 A | 1-15 |
| A | JP 3-264333 A (Ube Industries, Ltd.),<br>25 November, 1991 (25.11.91),<br>Claims<br>(Family: none) | 1-15 |
| A | JP 2000-119418 A (Du Pont-Toray Co., Ltd.),<br>25 April, 2000 (25.04.00),<br>Claims<br>(Family: none) | 1-15 |
| A | EP 1236756 A1 (Mitsui Chemicals, Inc.),<br>04 September, 2002 (04.09.02),<br>Claims<br>& WO 02/14406 A1 & KR 2002040853 A<br>& US 2003/0013838 A1 | 1-15 |
| A | EP 710690 A2 (SUMITOMO CHEMICAL CO., LTD.),<br>08 May, 1996 (08.05.96),<br>Claims<br>& JP 8-176300 A & CN 1131684 A<br>& US 5734008 A | 1-15 |

Form PCT/ISA/210 (continuation of second sheet) (July 1998)

## INTERNATIONAL SEARCH REPORT

International application No.
PCT/JP03/04085

C (Continuation). DOCUMENTS CONSIDERED TO BE RELEVANT

| Category* | Citation of document, with indication, where appropriate, of the relevant passages | Relevant to claim No. |
|---|---|---|
| A | US 6350844 B1 (Kaneka Corp.),<br>26 February, 2002 (26.02.02),<br>Claims<br>& JP 2001-72781 A & KR 2000035259 A<br>& TW 450982 A | 1-15 |

Form PCT/ISA/210 (continuation of second sheet) (July 1998)